(19) **Europäisches Patentamt**

**European Patent Office**

**Office européen des brevets**

(11) **EP 0 729 228 B1**

(12) **EUROPEAN PATENT SPECIFICATION**

(45) Date of publication and mention
of the grant of the patent:
**15.01.2003 Bulletin 2003/03**

(51) Int Cl.[7]: **H03H 1/00**, H03H 11/04,
H03H 15/00

(21) Application number: **95830049.3**

(22) Date of filing: **22.02.1995**

(54) **Basic cell for programmable analog time continuous filter**

Basiszelle für ein analoges programmierbares zeitkontinuierliches Filter

Cellule de base pour filtre analogique programmable à temps continu

(84) Designated Contracting States:
**DE FR GB IT**

(43) Date of publication of application:
**28.08.1996 Bulletin 1996/35**

(73) Proprietor: **STMicroelectronics S.r.l.**
**20041 Agrate Brianza (Milano) (IT)**

(72) Inventors:
- **Alini, Roberto**
  **I-27049 Stradella (IT)**
- **Brianti, Francesco**
  **I-29100 Piacenza (IT)**

- **Pisati, Valerio**
  **I-27049 Bosnasco (IT)**
- **Demicheli, Marco**
  **I-20070 Binago (IT)**

(74) Representative: **Botti, Mario**
**Botti & Ferrari S.r.l.,**
**Via Locatelli, 5**
**20124 Milano (IT)**

(56) References cited:
**EP-A- 0 260 785**      **DE-A- 3 939 906**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 729 228 B1

# EP 0 729 228 B1

**Description**

<u>Field of application</u>

The present invention relates to an elementary cell structure for programmable time-continuous analog filters and in particular for read/write operations on magnetic supports.

Specifically but not exclusively the present invention relates to a cell comprising an amplifier stage inserted between a first reference supply voltage and a second reference voltage having a first and a second input terminals and an output terminal.

The present invention also relates to a transverse analog filter and a delay chain provided by means of a series of cells of the above type.

<u>Prior art</u>

As known, in the specific field of application of the present invention there is a need to provide electronic circuits designed for processing analog signals during data read and write phases from and to a magnetic support, e. g. a hard disk of an electronic processor.

The signals must be processed in an appropriate manner to avoid data reading and memorization errors.

There is for example a technique known as Partial Response Signaling With Maximum Likelihood Sequence Detection (PRML) which provides only partial sampling of the frequency band of the input signal and the successive search for the highest correspondence possible between the output signal and the input signal sample.

Normally in a PRML architecture an analog signal picked up e.g. by a read/write head of the magnetic support is processed and reconstructed in digital format by means of an equalizing device. Specifically the analog signal is first subjected to an analog equalization by means of a variable-gain input amplifier and successively processed through a time-continuous low-pass analog filter. The majority of analog filters can be manufactured starting from low-pass elementary cells.

The output of the analog filter is successively sampled through an analog/digital converter and further processed through a transverse digital filter, e.g. the Finite Impulse Response (FIR) type which has a transfer function of the following type:

$$y(t) = a_0 + a_1 D^1 + ... + a_n D^n \qquad (1)$$

where:

$a_0, a_1,..., a_n$ are coefficients chosen according to the type of use of the filter, and

$D^1,..., D^n$ is the input signal delayed n times the unit delay.

Normally each of the elementary cells making up a FIR filter has a transfer function to supply at the output the input signal delayed according to a predetermined value, called unit delay.

German reference DE 39 39 906A1 teaches one way to connect a series of operational amplifiers to make delay lines used in a transversal filter. In this way, each operational amplifier causes the delay desired at the ouput with respect to the input.

The delay with which the input signal appears at the output is a function of the signal frequency. More specifically the delay is the derivative in relation to the frequency with changed sign of the transfer function phase between the input and the output.

The prior art proposes to provide the FIR filters in a digital or sampled time manner. These solutions are however affected by an error due to the quantization of the analog signal which must be converted into a digital signal and by another error introduced by the sampling of the signal and commonly called "aliasing" phenomenon.

The presence of these errors limits the use of digital or sampled time FIR filters in many applications as for example those for magnetic support read/write devices.

The technical problem underlying the present invention is to conceive an elementary cell structure of the analog type to provide time-continuous filters having structural and functional characteristics allowing replacing digital filters which still limit the use of the PRML technique in read/write devices provided in accordance with the prior art.

Another purpose of the present invention is to conceive a delay line achieved with a chain of elementary cells allowing introduction in the filtering phase of a delay of any predetermined value without thereby distorting the input signal either in phase or in amplitude.

## Summary of the Invention

The solution idea underlying the present invention is to provide a symmetrical structure of the time-continuous analog type comprising two identical half-cells provided starting from a transconductance amplifier stage.

The problem is solved by a transverse analog filter comprising a plurality of elementary cells in accordance with claim 1 and following.

The characteristics and advantages of the present invention are set forth in the description of an embodiment thereof given below by way of non-limiting example with reference to the annexed drawings.

## Brief description of the drawings

In the drawings:

FIG. 1 shows schematically an elementary low-pass analog cell in accordance with the present invention,

FIG. 2 shows schematically a first example of a transverse analog filter provided in accordance with the present invention,

FIG. 3 shows schematically a second example of a transverse analog filter provided in accordance with the present invention, and

FIGS. 4 and 5 show two circuit portions of another embodiment of the elementary analog cell in accordance with the present invention.

## Detailed description

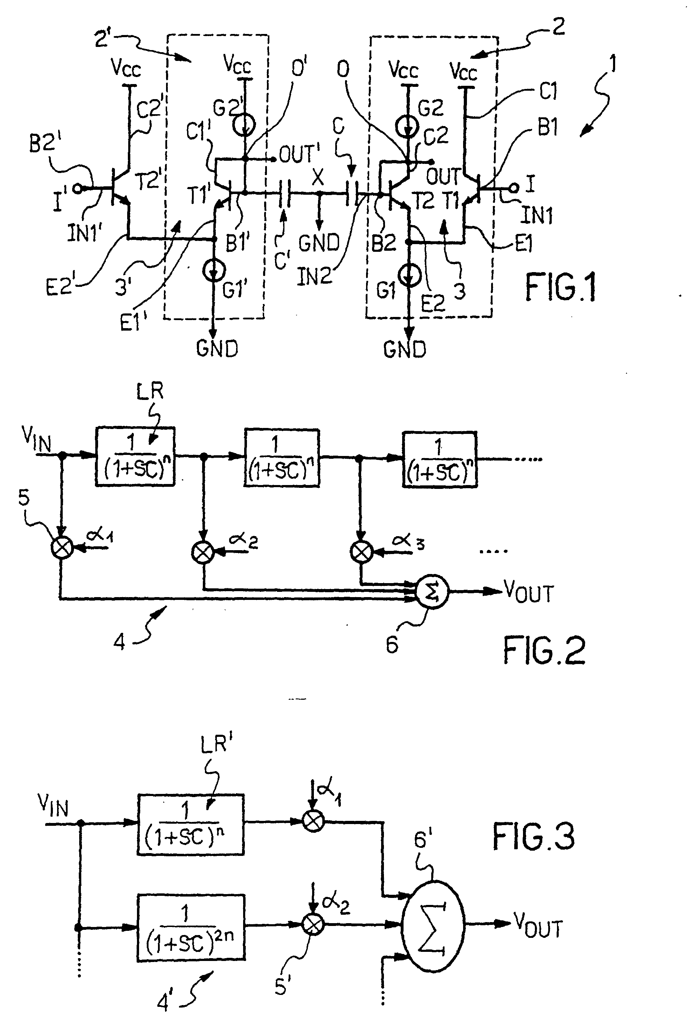

With particular reference FIG. 1 reference number 1 indicates as a whole and schematically an elementary analog cell structure provided in accordance with the present invention.

This structure is designed in particular but not exclusively for the manufacture of programmable time-continuous analog filters for read/write operations on magnetic supports.

The cell 1 comprises essentially two identical half-cells 2 and 2' inserted between a first reference supply voltage Vcc and a second reference voltage, e.g. a signal ground GND.

The first half-cell 2 comprises a transconductance amplifier stage 3 with an input terminal IN1 and an output terminal OUT.

The amplifier stage 3 comprises a pair of transistors T1 and T2 having their emitter terminals E1 and E2 respectively connected together and, through a bias current generator G1, to the second reference voltage GND.

The transistors T1 and T2 are, in the preferred embodiment shown here in FIG. 1, type NPN BJT bipolar transistors. The cell 1 in accordance with the present invention could also be provided by means of type PNP bipolar transistors or by means of field effect MOS transistors either of the NMOS or the PMOS type.

The transistor T1 has its collector terminal C1 connected to the reference supply voltage Vcc while the base terminal B1 of the same transistor T1 coincides with the input terminal IN1 of the amplifier stage 3.

The transistor T2 has its base terminal B2 and collector terminal C2 short-circuited together in an essentially diode configuration. The collector terminal C2 coincides with the output terminal OUT of the amplifier stage 3 and is connected to the reference supply voltage Vcc by means of a second generator G2 of bias current Ib.

Advantageously in accordance with the present invention the first generator G1 delivers a bias current 2*Ib double that delivered by the second generator G2.

The base - or control - terminal B2 of the transistor T2 is connected to a circuit node X for connection between the two half-cells 2 and 2' through a capacitor C.

The circuit node X can be connected to the second reference voltage GND or can be floating.

The structure of the second half-cell 2' is fully identical to and symmetrical with that of the first half-cell 2 described above. Therefore, for the sake of simplicity, a detailed description thereof is omitted only noting that all the elements corresponding to those of the first cell 2 are indicated in the figures with the same reference numbers and symbols but with the addition of a superscript.

As mentioned above, the first half-cell 2 and the second half-cell 2' are connected together in the circuit node X.

The input terminal IN1 of the amplifier stage 3 of the first half-cell 2 coincides with the first input terminal I of the cell 1 as a whole while the input terminal IN1' of the amplifier stage 3' of the second half-cell 2' coincides with the second input terminal I' of the cell 1.

The output terminals OUT and OUT' of the amplifier stages 3 and 3' are the output terminals O and O' of the cell 1.

The cell 1 of FIG. 1 is illustrated in a fully differential configuration which has better rejection to common mode signals and noise from the power supply. For the cell 1 it is possible to provide a single-ended configuration.

In any case an elementary low-pass cell is a circuit structure capable of providing a transfer function between its input and output terminals since it has essentially a single dominant pole at high frequencies.

The transfer function FdT of the cell 1 in accordance with the present invention is as follows:

$$FdT = V_{out}/V_{in} = (1 + s*\tau_c)\text{-}1 * (1 + s*\tau_{par})\text{-}1 \tag{2}$$

where:

$V_{in}$ is the input signal of the cell 1,

$V_{out}$ is the output signal of the cell 1,

$\tau_c$ is the time - or delay- constant linked to the dominant pole of the cell 1 and is equal to $2*C_{out}/g_m$ where $C_{out}$ is the equivalent output capacity and $g_m$ is the transconductance of the cell 1,

$\tau_{par}$ is the time - or delay - constant due to the presence of a parasite pole and is equal to $2*C_{par}/g_m$ where $C_{par}$ is the equivalent parasite capacity of the cell 1.

In practical applications it is permissible to ignore the effect of this parasite pole which has a much higher frequency than the dominant pole. The transfer function can be simplified as follows:

$$FdT = V_{out}/V_{in}(\omega) = (1 + s*\tau_c)\text{-}1 \tag{3}$$

Recalling that the delay with which the input signal $V_{in}$ appears at the output is, depending on the frequency, the derivative of the transfer function FdT with the sign changed, for the cell 1 we have:

$$R(\omega) = \tau_c * (1 + \omega*\tau_c)\text{-}1 \tag{4}$$

where $R(\omega)$ is the delay of the output signal as a function of the pulsation $\omega$.

For input signals $V_{in}$ having maximum pulsations in the frequency spectrum lower than the cut-off pulsations of the cell 1, cut-off pulsation which is equal to $\omega_c = 1/\tau_c$ of formula (3), the output signal $V_{out}$ from the cell 1 is distorted neither in phase nor in amplitude but only delayed by a time interval equal to $\tau_c$.

Thus was obtained a circuit structure having the great advantage of being able to delay the input signal in accordance with a predetermined delay value $\tau_c$, but without introducing any distortion.

The cell 1 can thus be considered as a constant delay element $\tau_c$, also equal to $1/2*\pi*f_c$, where $f_c$ is the cut-off frequency of the cell 1.

This delay $\tau_c$ is however linked to the band of frequencies of the input signal $V_{in}$, which must not have any component in frequency greater than $f_c/10$ to not have distortion of the output signal $V_{out}$.

This constraint in reality limits the possible delay for processing of a given input signal $V_{in}$ at the value $10*2*\pi*f_{maxi}$, where $f_{maxi}$ is the maximum frequency of the band of the input signal $V_{in}$.

To obviate this shortcoming it is possible to provided a delay line LR by means of a cascade of cells 1. Specifically, it is sufficient to connect in parallel the outputs OUT and OUT' of a cell with the inputs I, I' of another cell to obtain a delay line LR consisting of two base cells. It is clear that the base structure can be repeated depending on necessities by connecting in cascade together a number n of cells 1.

The resulting line LR has a delay equal to $n*\tau_c$, i.e. a cut-off frequency $f_c$ equal to $n*f_{maxi}$, where n is the number of cells 1 cascaded.

To eliminate all noise from the output signal it is appropriate to provide a delay line LR by cascading ten cells 1. In this manner the frequency limit $f_c/10$ imposed by the delay line LR would be identical to the highest frequency value contained in the input signal $V_{in}$.

In practice the connection in cascade of only five cells 1 is acceptable so as to gain in terms of dispersed power.

In reality a delay line LR consisting of the cascade of n cells 1 of the low-pass type all having the same cut-off frequency $f_c$ exhibits a final cut-off frequency F at the output of the chain (at the point a - 3dB) approximately equal to:

$$F = f_c/\sqrt{n} \tag{5}$$

The delay line LR complies with the requirement for having a relatively flat delay but can introduce elements which are not ideal as concerns the frequency response of the output signal. The line LR attenuates the high frequency components of the input signal $V_{in}$.

This apparently negative feature does not really represent a true problem when the delay line LR is used for providing recursive filters such as for example transverse filters FIR.

A first example of a FIR transverse filter 4 is shown schematically in FIG. 2.

The filter 4 comprises a cascade of identical delay lines LR connected through multiplier nodes 5 to a final summation node 6.

The signal Vo output by the node 6 is obtained by means of a transfer function determined from formula (1) with a unitary delay equal to the delay of the line LR.

The coefficients $a_1,..., a_n$ are input at the multiplier nodes 5.

FIG. 3 shows schematically a second possible embodiment of a filter 4' of the transverse FIR type.

The filter 4' comprises an summation node 6' to which lead a plurality of delay lines LR' each of which is connected to the summation node 6' through a multiplier node 5'.

Each of the n delay lines LR' supplies at output a signal delayed n times which is multiplied in each of the nodes 5' by the relative coefficient $a_1,..., a_n$ in such a manner as to obtain a transfer function in accordance with formula (1).

In both the filter examples 4 and 4' the same signal delayed in time is added after being multiplied by appropriate coefficients. Then the final result is an output signal having the desired phase and amplitude characteristics and this allows overcoming the typical limitations of the delay lines LR provided by a simple cascade of cells 1.

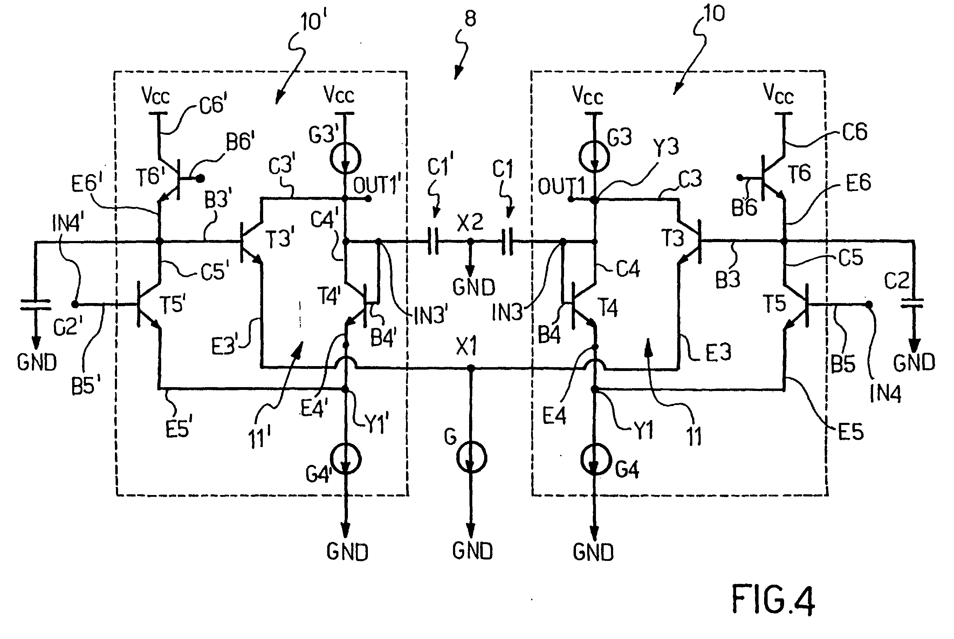

In FIG. 4 is proposed a second embodiment of an elementary analog cell in accordance with the present invention.

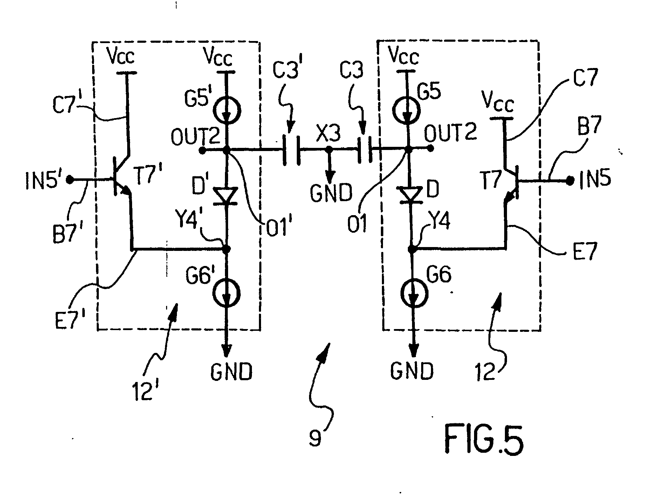

The cell comprises an input stage 8 and an output stage 9. The structure of the output stage 9 is shown schematically in FIG. 5.

The input stage 8 comprises two identical input half-stages 10 and 10' inserted between a first reference supply voltage Vcc and a second reference voltage, e.g. a signal ground GND.

The first input half-stage 10 comprises a transconductance amplifier stage 11, an input terminal IN4 and an intermediate output terminal OUT1.

The transconductance amplifier stage 11 comprises a pair of ransistors T4 and T5 whose emitter terminals E4 and E5 are connected together to form a first circuit node Y1.

The circuit node Y1 is connected to the second reference voltage GND through a second bias current generator G4 while the base terminal B5 of the transistor T5 coincides with the input terminal IN4 of the half-stage 10.

The transistor T4 has its base terminal B4 and collector terminal C4 short-circuited together and to a circuit node Y3. The collector C4 coincides with the intermediate output terminal OUT1 of the input half-stage 10.

The circuit node Y3 is connected through a first generator G3 of bias current 2*Ib to the reference supply voltage Vcc.

Advantageously in accordance with the present invention the second generator G4 delivers a bias current 2*Ib identical to that delivered by the first generator G3.

There is provided a third transistor T3 having its own base terminal B3 connected to the collector C5 of the transistor T5 and the emitter terminal E3 connected to a first circuit node X1 common to the two half-stages 10 and 10'.

The common circuit node X1 is connected to the second reference voltage GND through a common generator G of bias current 2*Ib. The value of this generator G is equal to that of the generators G3 and G4.

The terminal OUT1 is connected to a second circuit node X2 common to the two half-stages 10 and 11 through a first capacitor $C_1$. The common circuit node X2 is also connected to the second reference voltage GND or may remain floating.

The input half-stage 10 comprises additionally a bias transistor T6 inserted between the first reference supply voltage Vcc and the collector C5 of the transistor T5. This collector C5 is advantageously connected to the second reference voltage GND through a second capacitor $C_2$.

On the base terminal B6 of the transistor T6 is applied a bias voltage Vb2.

The structure of the second half-stage 11 is fully identical to and symmetrical with that of the first half-stage 10 described above. Therefore, for the sake of brevity, a detailed description thereof is omitted with the note that all the elements corresponding to those of the first half-stage 10 are indicated in FIG. 4 by the same reference numbers and symbols but with the addition of a superscript.

It is only remarked that the input half-stage 10 and the input half-stage 10' are connected together in the first common circuit node X1 and the second common circuit node X2.

Now with particular reference to the example of FIG. 5 there is described the structure of the output stage 9 of the cell. Operation of the input stage 8 and the output stage 9 is described below.

The output stage 9 has two intermediate input terminals IN5 and IN5' and two final output terminals OUT2 and OUT2'.

The intermediate output terminals OUT1 and OUT1' of the input stage 8 are connected to the intermediate input terminals IN5 and IN5' of the output stage 9.

The output stage 9 comprises two identical output half-stages 12 and 12' inserted between the first reference supply voltage Vcc and the second reference voltage GND.

The half-stage 12 comprises a transistor T7 having its base - or control - terminal B7 coinciding with the input IN5. The collector terminal C7 of the transistor T7 is connected to the first reference supply voltage Vcc. The emitter terminal E7 of the transistor T7 is connected towards the second reference voltage GND through a bias current generator G6.

The half-stage 12 comprises in addition a diode D inserted between the final output terminal OUT2 and the emitter E7.

The final output terminal OUT2 is also connected to the first reference voltage Vcc through a generator G5 of bias current 2*Ib.

Advantageously the generator G5 delivers a bias current 2*Ib equal to that delivered by the first generator G3 and the second generator G4 and by the common generator G.

The generator G6 delivers a bias current 4*Ib which is double than the bias current delivered by the generator G5.

The final output terminal OUT2 is connected at a common circuit node X3 to the two half-stages 12 and 12' through a capacitor $C_3$. The node X3 is connected to the second reference voltage GND.

The structure of the second half-stage 12' is fully identical to and symmetrical with that of the first half-stage 12 described above. Therefore a detailed description thereof is omitted with the only notice that all the elements corresponding to those of the first half-stage 12 are indicated in FIG. 5 by the same reference numbers and symbols but with the addition of a superscript.

parallel can be drawn between the structure of the cell as a whole as shown in FIGS. 4 and 5 and the structure of the more compact cell 1 of FIG. 1 considering that the input terminal IN4 of the half-stage 10 corresponds to the first input terminal I of the cell 1 while the second input terminal IN4' of the half-stage 10' corresponds to the second input terminal I' of the cell 1.

Similarly, the final output terminals OUT2 and OUT2' of the output stage 9 correspond to the output terminals OUT and OUT' of the cell 1.

Operation of this second embodiment of the structure of the cell in accordance with the present invention is now discussed.

The transfer function FdT1 of the input stage 8 of the cell is as follows:

$$FdT1 = V_{out1}/V_{in} = (1 + s*\tau'_c/2)*(1 + s*1.5\tau'_c + s2\tau'_c)-1 \qquad (6)$$

while the transfer function FdT2 of the output stage 9 of the cell is as follows:

$$FdT2 = V_{out2}/V_{out1} = 1 * (1 + s*\tau'_c)-1 \qquad (7)$$

where:

$V_{out1}$ is the intermediate output signal of the input stage 8; the one on the outputs OUT1 and OUT1'

$V_{out2}$ is the final output signal of the cell;

$V_{in}$ is the input signal of the cell;

$\tau'_c$ is the time constant or delay linked to the dominant pole of the cell and is equal to $2*C'_{out}/g'_m$, where $C'_{out}$ is the equivalent output capacity and $g'_m$ is the transconductance of the cell.

There is thus obtained the overall transfer function FdT' of the cell equal to:

$$FdT' = V_{out2}/V_{in} = (1 + s*\tau'_c/2)*(1 + s*1.5\tau'_c + s2\tau'_c)\text{-}1*$$

$$*(1 * (1 + s*\tau'_c)\text{-}1) \qquad (8)$$

The transfer function FdT' given by formula (8) exhibits a zero on the left which permits partial compensation of the phase effect introduced by the left-hand poles.
The effect of a zero on the left is to delete a pole on the left.
This zero therefore does not increase the delay of the cell. Indeed, as may be deduced from formula (8), recalling that the delay with which the input signal $V_{in}$ appears at the output is a function of the frequency and in particular is the derivative of the transfer function FdT' with changed sign, the delay of the cell with pulsation $\omega$ null is equal to:

$$R(\omega)\,|_{\omega=0} = 2*\tau'_c \qquad (9)$$

However, the presence of the zero on the left reduces the phase distortion making it negligible up to frequencies equal to $f'_c$ (where the distortion is less than 1%) where $f'_c$ is the cut-off frequency of the cell equal to $1/(2*\pi *\tau'_c)$.
There is thus obtained greater linearity in the group delay transfer characteristic for a cascade of cells allowing using input signals with the highest frequency content $f'_{maxi}$ which reaches $f'_c$.
Using a plurality of cells it is possible to provide delay lines LR and transverse filters in a manner quite similar to that described in relation to the analog cell 1.
To the-cells, to the delay lines and to the filters in accordance with the present invention there can be made modifications and variations in a manner apparent for one of ordinary skill in the art without however going beyond the protective scope of the present application.
For example, the cell of FIGS. 4 and 5 is illustrated in a configuration of the fully differential type offering better rejection to common mode signals and noise from the power supply. For this cell it is also possible to provide a "single ended" type configuration.
Furthermore, the transistors T3, T4, T5, T6 and T7 are described as type NPN BJT bipolar transistors. The cell in accordance with the present invention could however be provided by means of type PNP BJT bipolar transistors or field effect MOS transistors of either the NMOS type or the PMOS type.

**Claims**

1. Elementary cell structure in a programmable time-continuous analog filters and in particular for the processing of analog signals in read/write operations on magnetic supports, including an amplifier stage inserted between a first reference supply voltage (Vcc) and a second reference voltage (GND) and having at least one input terminal (I) and at least one output terminal (OUT) and **characterised in that** said amplifier stage comprises a pair of structurally identical half-cells (2,2') with each provided with a first transistor (T1, T2') coupled to said input terminal (I, I') at a control gate and coupled to said first reference supply voltage (Vcc) at a first conduction terminal, and also provided with a second transistor (T2, T1') having said output terminal (OUT, OUT')as a control gate coupled to a first conduction terminal, said output terminal (OUT, OUT') coupled to said first reference supply voltage through a first current generator (G2, G2'), and said second transistor (T2, T1') having a second conduction terminal coupled to a second conduction terminal of said first transistor (T1, T2'), which conduction terminals are in turn coupled to said second reference voltage (GND) through a second current generator (G1, G1'), each half-cell connected to the other half-cell through a common circuit node (X).

2. Time-continuous analog delay line **characterised in that** it comprises a cascade of cells in accordance with claim 1.

3. Transverse time-continuous analog filter **characterised in that** it comprises at least one time-continuous analog delay line in accordance with claim 2.

4. Transverse time-continuous analog filter in accordance with claim 3 **characterised in that** it comprises a cascade of identical time-continuous analog delay lines (LR) connected through multiplier nodes (5) to a final summation node (6).

5. Elementary cell structure in accordance with claim 1 **characterised in that** each half-cell (2,2') comprises at least one pair of type NPN or type PNP bipolar transistors (T1,T2).

6. Elementary cell structure for analog filters in accordance with claim 1 **characterised in that** each half-cell (2,2') comprises at least one pair of field-effect or MOS transistors (M1,M2).

7. Elementary cell structure for programmable time-continuous analog filters and in particular for the processing of analog signals in read/write operations on magnetic supports, including an amplifier stage inserted between a first reference supply voltage (Vcc) and a second reference voltage (GND) and having at least one input terminal (IN4) and at least one output terminal (OUT1) and **characterised in that** it comprises an input stage (8) provided by means of a pair of structurally identical half-stages (10,10') each half stage having an input stage including first transistor (T5, T5') coupled to said input terminal (IN4, IN4') at a control gate and coupled to said first reference supply voltage (Vcc) through a first conduction terminal, and also provided with a second transistor (T4, T4') having said output terminal (OUT1, OUT1') as a control gate coupled to a first conduction terminal, said output terminal (OUT1, OUT1') coupled to said first reference supply voltage (Vcc) through a first current generator (G3, G3'), and said second transistor (T4, T4') having a second conduction terminal coupled to a second conduction terminal of said first transistor (T5, T5'), which said second terminals are in turn coupled to said second reference voltage (GND) through a second current generator (G4, G4'), and said cell structure including an output stage (9) provided with a pair of structurally identical half-stages (12,12') with each of said half-stages (10,10';12,12') connected to its twin half-stage through a common circuit node (X1,X2,X3).

8. Time-continuous analog delay line **characterised in that** it comprises a cascade of elementary cells in accordance with claim 7.

9. Transverse time-continuous analog filter **characterised in that** it comprises at least one time continuous analog delay line in accordance with claim 8.


**Patentansprüche**

1. Elementarzellenstruktur in einem programmierbaren, zeitkontinuierlichen Analogfilter und im besonderen für die Verarbeitung von Analogsignalen bei Lese/Schreiboperationen auf magnetischen Trägern, aufweisend eine Verstärkerstufe, die zwischen eine erste Referenzversorgungsspannung (Vcc) und eine zweite Referenzspannung (GND) eingefügt ist und mindestens einen Einganganschluß (I) und mindestens einen Ausgangsanschluß (OUT) aufweist,

**dadurch gekennzeichnet,**
**daß** die Verstärkerstufe ein Paar von strukturell identischen Halbzellen (2, 2') aufweist, je ausgestattet mit einem ersten Transistor (T1, T2'), der an einem Steueranschluß mit dem Eingangsanschluß (I, I') und an einem ersten Stromflussanschluß mit der ersten Referenzversorgungsspannung (Vcc) gekoppelt ist, und mit einem zweiten Transistor (T2, T1'), der den Ausgangsanschluß (OUT, OUT') als einen Steueranschluß aufweist, der mit einem ersten Stromflussanschluß gekoppelt ist, wobei der Ausgangsanschluß (OUT, OUT') mit der ersten Referenzversorgungsspannung über einen ersten Stromgenerator (12, 12') gekoppelt ist und wobei der zweite Transistor (T2, T1') einen zweiten Stromflussanschluß aufweist, der mit einem zweiten Stromflussanschluß des ersten Transistors (T1, T2') gekoppelt ist. wobei diese Stromflussanschlüsse mit der zweiten Referenzspannung (GND) über einen zweiten Stromgenerator (G1, G1') gekoppelt sind, und jede Halbzelle mit der anderen Halbzelle über einen gemeinsamen Schaltungs-Knoten (X) verbunden ist.

2. Zeitkontinuierliche, analoge Verzögerungsleitung, **dadurch gekennzeichnet, daß** sie eine Kaskade von Zellen entsprechend Anspruch 1 aufweist.

3. Zeitkontinuierliches analoges Querfilter, **dadurch gekennzeichnet, daß** es mindestens eine zeitkontinuierliche analoge Verzögerungsleitung entsprechend Anspruch 2 aufweist.

4. Zeitkontinuierliches analoges Querfilter nach Anspruch 3, **dadurch gekennzeichnet, daß** es eine Kaskade von identischen zeitkontinuierlichen, analogen Verzögerungsleitungen (LR) aufweist, die über Multiplexer-Knoten (5) mit einem finalen Summations-Knoten (6) verbunden sind.

5. Elementarzellenstruktur nach Anspruch 1, **dadurch gekennzeichnet, daß** jede Halbzelle (2, 2') mindestens ein Paar Bipolartransistoren (T1, T2) vom NPN-Typ oder PNP-Typ aufweist.

6. Elementarzellenstruktur für Analogfilter nach Anspruch 1, **dadurch gekennzeichnet, daß** jede Halbzelle (2, 2') mindestens ein Paar von Feldeffekt- oder MOS-Transistoren (M1, M2) aufweist.

7. Elementarzellenstruktur für programmierbare, zeitkontinuierliche Analogfilter und insbesondere für die Verarbeitung von Analogsignalen bei Lese/Schreiboperationen auf magnetischen Trägern, aufweisend eine Verstärkerstufe, die zwischen eine erste Referenzversorgungsspannung (Vcc) und eine zweite Referenzspannung (GND) eingefügt ist und mindestens einen Eingangsanschluß (IN4) und mindestens einen Ausgangsanschluß (OUT1) aufweist,

**dadurch gekennzeichnet,**

**daß** sie eine Eingangsstufe (8) aufweist, die mittels eines Paars von strukturell identischen Halbstufen (10, 10') gebildet ist, wobei jede Halbstufe eine Eingangsstufe aufweist, die einen ersten Transistor (T5, T5') aufweist, der an einem Steueranschluß mit dem Eingangsanschluß (IN4, IN4') gekoppelt ist und mit der ersten Referenzversorgungsspannung (Vcc) über einen ersten Stromflussanschluß gekoppelt ist, und einen zweiten Transistor (T4, T4') aufweist, der den Ausgangsanschluß (OUT1, OUT1') als einen Steueranschluß aufweist, der mit einem ersten Stromflussanschluß gekoppelt ist, wobei der Ausgangsanschluß (OUT1, OUT1') mit der ersten Referenzversorgungsspannung (Vcc) über einen ersten Stromgenerator (G3, G3') gekoppelt ist und der zweite Transistor (T4, T4') einen zweiten Stromflussanschluß aufweist, der an einen zweiten Stromflussanschluß des ersten Transistors (T5, T5') gekoppelt ist, wobei die zweiten Anschlüsse mit der zweiten Referenzspannung (GND) über einen zweiten Stromgenerator (G4, G4') gekoppelt sind, und wobei die Zellenstruktur eine Ausgangsstufe (9) aufweist, die mit einem Paar von strukturell identischen Halbstufen (12, 12'), versehen ist, wobei jede der Halbstufen (10, 10'; 12, 12') mit ihrer Zwillings-Halbstufe über einen gemeinsamen Schaltungsknoten (X1, X2, X3) verbunden ist.

8. Zeitkontinuierliche, analoge Verzögerungsleitung, **dadurch gekennzeichnet, daß** sie eine Kaskade von Elementarzellen nach Anspruch 7 aufweist.

9. Zeitkontinuierliches analoges Querfilter, **dadurch gekennzeichnet, daß** es mindestens eine zeitkontinuierliche, analoge Verzögerungsleitung nach Anspruch 8 aufweist.

## Revendications

1. Structure de cellule élémentaire dans des filtres analogiques à continuité temporelle programmables et en particulier pour le traitement de signaux analogiques dans des opérations de lecture/écriture sur des supports magnétiques, comprenant un étage amplificateur inséré entre une première tension d'alimentation de référence (Vcc) et une seconde tension de référence (GND) et possédant au moins une borne d'entrée (I) et au moins une borne de sortie (OUT) et **caractérisée en ce que** ledit étage amplificateur comprend une paire de demi-cellules structurellement identiques (2, 2') chacune pourvue d'un premier transistor (T1, T2') couplé à ladite borne d'entrée (I, I') sur une grille de commande et couplé à ladite première tension d'alimentation de référence (Vcc) sur une première borne de conduction, et également pourvue d'un second transistor (T2, T1') ayant ladite borne de sortie (OUT, OUT') comme grille de commande couplée à une première borne de conduction, ladite borne de sortie (OUT, OUT') couplée à ladite première tension d'alimentation de référence par l'intermédiaire d'un premier générateur de courant (G2, G2'), et ledit second transistor (T2, T1') ayant une seconde borne de conduction couplée à une seconde borne de conduction dudit premier transistor (T1, T2'), lesquelles bornes de conduction sont à leur tour couplées à ladite seconde tension de référence (GND) par l'intermédiaire d'un second générateur de courant (G1, G1'), chaque demi-cellule reliée à l'autre demi-cellule par l'intermédiaire d'un noeud de circuit commun (X).

2. Ligne à retard analogique à continuité temporelle, **caractérisée en ce qu'**elle comprend une cascade de cellules selon la revendication 1.

3. Filtre analogique à continuité temporelle transversal, **caractérisé en ce qu'**il comprend au moins une ligne à retard analogique à continuité temporelle selon la revendication 2.

**4.** Filtre analogique à continuité temporelle transversal selon la revendication 3, **caractérisé en ce qu'**il comprend une cascade de lignes à retard analogiques à continuité temporelle identiques (LR) reliées par l'intermédiaire de noeuds multiplicateurs (5) à un noeud de sommation final (6).

**5.** Structure de cellule élémentaire selon la revendication 1, **caractérisée en ce que** chaque demi-cellule (2, 2') comprend au moins une paire de transistors bipolaires de type NPN ou de type PNP (T1, T2).

**6.** Structure de cellule élémentaire pour filtres analogiques selon la revendication 1, **caractérisée en ce que** chaque demi-cellule (2, 2') comprend au moins une paire de transistors MOS ou à effet de champ (M1, M2).

**7.** Structure de cellule élémentaire pour filtres analogiques à continuité temporelle programmables et en particulier pour le traitement de signaux analogiques dans des opérations de lecture/écriture sur des supports magnétiques, comprenant un étage amplificateur inséré entre une première tension d'alimentation de référence (Vcc) et une seconde tension de référence (GND) et possédant au moins une borne d'entrée (IN4) et au moins une borne de sortie (CUT1) et **caractérisée en ce qu'**elle comprend un étage d'entrée (8) pourvu au moyen d'une paire de demi-étages structurellement identiques (10, 10'), chaque demi-étage ayant un étage d'entrée comprenant un premier transistor (T5, T5') couplé à ladite borne d'entrée (IN4, IN4') sur une grille de commande et couplé à ladite première tension d'alimentation de référence (Vcc) par l'intermédiaire d'une première borne de conduction, et également pourvu d'un second transistor (T4, T4') ayant ladite borne de sortie (OUT1, OUT1') comme grille de commande couplée à une première borne de conduction, ladite borne de sortie (OUT1, OUT') couplée à ladite première tension d'alimentation de référence (Vcc) a par l'intermédiaire d'un premier générateur de courant (G3, G3'), et ledit second transistor (T4, T4') ayant une seconde borne de conduction couplée à une seconde borne de conduction dudit premier transistor (T5, T5'), lesquelles dites secondes homes sont à leur tour couplées à ladite seconde tension de référence (GND) par l'intermédiaire d'un second générateur de courant (G4, G4'), et ladite structure de cellule incluant un étage de sortie (9) pourvu d'une paire de demi-étages structurellement identiques (12, 12') avec chacun desdits demi-étages (10, 10' ; 12, 12') relié à son demi-étage jumeau par l'intermédiaire d'un noeud de circuit commun (X1, X2, X3).

**8.** Ligne à retard analogique à continuité temporelle, **caractérisée en ce qu'**elle comprend une cascade de cellules selon la revendication 7.

**9.** Filtre analogique à continuité temporelle transversal, **caractérisé en ce qu'**il comprend au moins une ligne à retard analogique à continuité temporelle selon la revendication 8.

**FIG.1**

**FIG.2**

**FIG.3**

FIG.4

FIG.5